Europäisches Patentamt

European Patent Office

Office européen des brevets

(11) Publication number: **0 214 239 B1**

# EUROPEAN PATENT SPECIFICATION

(45) Date of publication of patent specification: **30.05.90**

(51) Int. Cl.⁵: **G 01 R 19/155, G 01 R 31/02**

(21) Application number: **86901686.5**

(22) Date of filing: **24.02.86**

(86) International application number:
**PCT/US86/00380**

(87) International publication number:
**WO 86/05277 12.09.86 Gazette 86/20**

(54) **METHOD AND CIRCUIT FOR DETECTING A FAULT CONDITION.**

(30) Priority: **28.02.85 US 706696**

(43) Date of publication of application:
**18.03.87 Bulletin 87/12**

(45) Publication of the grant of the patent:
**30.05.90 Bulletin 90/22**

(84) Designated Contracting States:
**DE FR GB**

(56) References cited:

**Machine Design, volume 50, no. 4, February 1978: "Capacitor cancels current-monitor errors", page 46**

**New Electronics, volume 15, no. 24, December 1982, Harpenden, Herts., (GB); J.M.Button: "Signal line voltage monitor", page 18**

(73) Proprietor: **NCR CORPORATION
World Headquarters
Dayton, Ohio 45479 (US)**

(72) Inventor: **PIPKORN, Mark, George
3450 35th Avenue South
Minneapolis, MN 55406 (US)**

(74) Representative: **Robinson, Robert George
International Patent Department NCR Limited
206 Marylebone Road
London NW1 6LY (GB)**

Courier Press, Leamington Spa, England.

## Description

Technical Field

This invention relates to a method for detecting a fault in a voltage distribution bus adapted to be supplied with a line voltage level by a voltage supply and which is connected to utilization means utilizing the line voltage.

The invention also relates to a test circuit for detecting a fault condition in a voltage distribution bus adapted to be supplied with a line voltage by a voltage supply and which is connected to utilization means utilizing the line voltage.

Background Art

In a data processing system, one type of parameter which is especially important to the operation of the system is the bus voltage appearing on the input connection to various printed circuit boards on which are located the processing elements that form the data processing system. In monitoring such bus voltages, a zero voltage reading may indicate an actual zero bus voltage or may be due to various other causes such as open or short circuits in the monitoring device or its connections.

Disclosure of the Invention

It is an object of the present invention to provide a method and a test circuit of the kind specified having the capability of automatically determining the status of a fault indication.

Therefore, according to one aspect of the present invention, there is provided a method of the kind specified, characterized by the steps of: connecting a test circuit including a resistor network and a data acquisition circuit to said voltage distribution bus such that said resistor network is connected between said voltage distribution bus and ground, supplying a current through a first circuit path in said data acquisition circuit and sensing a first voltage drop in said first circuit path, forming a second circuit path including a first resistor in said test circuit, passing said current through said second circuit path, and sensing a second voltage drop in said second circuit path, forming a third circuit path including a second resistor having a greater resistance than the first resistor and included in said resistor network, passing said current through said third circuit path and sensing a third voltage drop in said third circuit path, comparing the third voltage drop with either the second voltage drop and/or the first voltage drop and/or the maximum detectable voltage drop, and generating a respective one out of a number of alarm actuating signals when a) the second voltage drop is greater than the third voltage drop, b) the third voltage drop is greater than the second voltage drop, c) the first voltage drop is equal to the third voltage drop, d) the third voltage drop is greater than the maximum detectable voltage drop.

According to another aspect of the invention, there is provided a test circuit of the kind specified, characterized in that said test circuit includes a resistor network adapted for connection between said voltage distribution bus and ground and a data acquisition circuit adapted for connection to said resistor network and including voltage sensing means connected to an output of said data acquisition circuit, and in that there are provided first switching means adapted to connect a first circuit path in said data acquisition circuit to said voltage sensing means, second switching means adapted to connect a second circuit path including a first resistor to said voltage sensing means, third switching means adapted to connect a second resistor having a value greater than said first resistor and included in said resistor network to said voltage sensing means, and fourth switching means adapted to connect a current source to said data acquisition circuit, and processor means responsive to the output of said voltage sensing means and adapted to operate said fourth switching means and to successively operate said first, second and third switching means thereby providing respective first, second and third voltage drops, whereby said processor means is adapted to generate a respective one of a number of alarm actuating signals when a) the second voltage drop is greater than the third voltage drop, b) the third voltage drop is greater than the second voltage drop, c) the first voltage drop is equal to the third voltage drop, d) the third voltage drop is greater than the maximum detectable voltage drop.

It will be appreciated that a method and test circuit according to the invention have the advantage that the status of a fault condition can be determined without requiring the utilization of a plurality of additional sensing lines and associated measuring devices.

Brief Description of the Drawings

One embodiment of the invention will now be described by way of example with reference to the accompanying drawings, in which:

Fig. 1 is a block diagram of the sensing system which includes the circuit of the present invention;

Fig. 2 is a circuit diagram of the present invention; and

Fig. 3 is a flow chart of the method for determining the status of various detected fault conditions.

Best Mode or Carrying Out the Invention

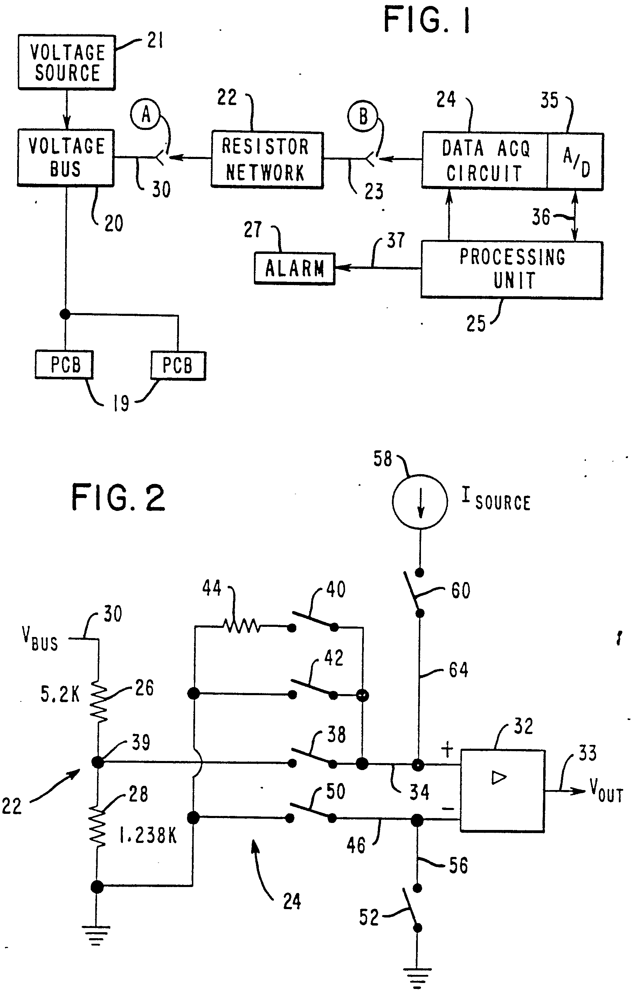

Referring now to Fig. 1, there is shown a block diagram of a portion of a data processing system which includes the circuit of the present invention. A voltage distribution bus 20 is connected to a voltage source 21 which supplies voltage to the bus 20 for operating elements in the data processing system such as printed circuit boards 19 connected to the bus 20. Also connected to the bus 20 over line 30 is a resistor network 22 which is connected over bus 23 to a data acquisition circuit 24. The circuit 24 will monitor the voltage level appearing on the bus 20 and when such level falls to zero, a processing unit 25 of the data processing system will determine the nature of the cause for such voltage reading. The cause of such reading may include a failure of, the voltage source 21, the distribution bus 20 or the presence of an open or short circuit at point A or point B in the circuit. The resistor network 22 is designed to prescale the reading of the voltages appearing on the bus 20 to a range of plus or minus one volt when the bus voltages appearing on the bus 20 are at the required bus voltage level, e.g. plus twelve volts etc.

Referring now to Fig. 2, there is shown a schematic diagram of the resistor network 22 and the data acquisition circuit 24 of the present invention. The resistor network 22 includes the resistors 26 and 28 which are wired in series over line 30 with the voltage bus 20. The resistor 28 is connected to a remote ground or ground bus. The acquisition circuit 24 includes a differential amplifier 32 whose positive or non-inverting input is connected over line 34 and through switch 38 to a node 39 which is located intermediate the resistors 26 and 28. The negative or inverting input of the amplifier 32 is connected over line 46 and through the switch 50 to the other side of the resistor 28.

The acquisition circuit 24 further includes a parallel network including switches 40 and 42 and a IK test resistor 44 which are wired across the input lines 34 and 46 of the amplifier 32. The value of the resistor 44 must equal the total resistance of the parallel combination of the resistors 26 and 28. The amplifier 32 will normally measure the voltage drop across the resistor 28 when switches 38 and 50 are closed. The output line 33 of the amplifier 32 is connected to a A/D converter 35 whose output signal is connected over line 36 (Fig. 1) to the processing unit 25 which in turn is connected over line 37 to any type of alarm device 27 which may take the form of generating a flag or the display of an alarm condition on a CRT screen. The switch 50 is normally closed during the operation of the data acquisition circuit 24. The circuit 24 further includes a constant current source 58, and switches 52 and 60 for controlling the operation of the acquisition circuit in a manner to be described more fully hereafter. As previously described, if the output voltage signal Vout of the amplifier 32 indicates the voltage on the bus 20 is zero, it is not known whether the reading is a result of a failure in the voltage source 21 or the presence of an open or short circuit. The present invention provides a method for detecting the cause of such a voltage reading and the setting of an alarm upon the detection of such a condition if the condition is required to be reported. The switches in the circuit of Fig. 2 may comprise transistors or other type of mechanical and electronic switches which can be electrically operated.

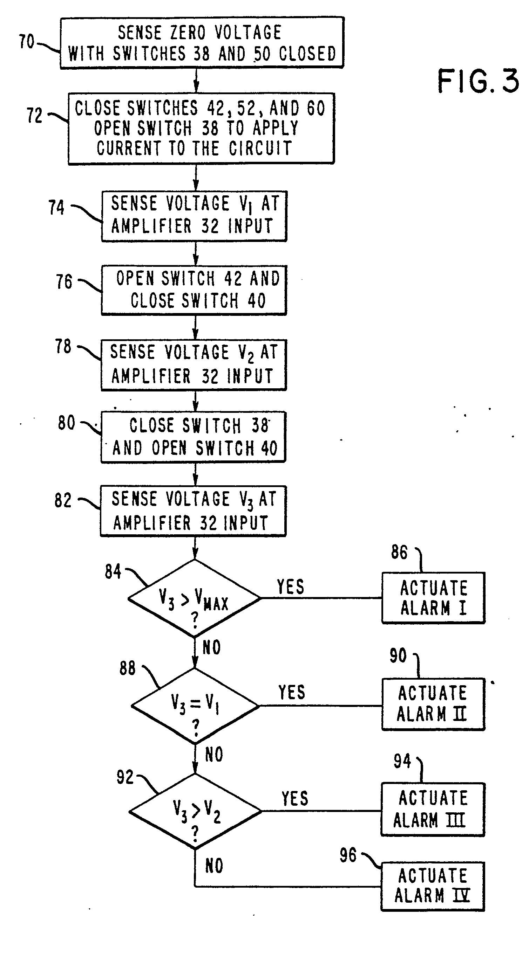

Referring now to Fig. 3, there is shown a flow chart of the operation of the data acquisition circuit 24 which may, in the present embodiment, comprise a routine performed by the processing unit 25. In monitoring the voltage drop across the resistor 28 with switches 38 and 50 closed, the processing unit will, upon detecting (block 70) a zero voltage level, close (block 72) switches 60, 42, and 52 and open switch 38 allowing one milliamp of current to flow from a constant current source 58 (Fig. 2) through the closed switches to ground enabling the amplifier 32 to sense (block 74) a voltage drop $V_1$ across the circuit which includes the inherent resistance of the circuit due to the length of lines 34 and 46 together with the resistance of the switches in the circuit. The processing unit 25 will then open switch 42 and close switch 40 (block 76) allowing the amplifier 32 to sense (block 78) a voltage drop $V_2$ across the circuit which includes the resistor 44. The processing unit will then open switch 40 and close switch 38 (bloc 80) allowing the amplifier 32 to sense (block 82) a voltage drop $V_3$ across the circuit which includes the resistor 28. The voltage drop $V_3$ is then compared with a voltage drop $V_{max}$ (block 84) where $V_{max}$ is the maximum voltage that can be sensed by the amplifier 32. If the voltage drop $V_3$ is greater than $V_{max}$, then there is a break at point B (Fig. 1) which may be the result of an open circuit in one of the lines in bus 23. This condition results in the generation of a signal which activates a first alarm condition (block 86) notifying the operator of the existence of such a fault condition. If $V_3$ is less than $V_{max}$, the voltage drops $V_1$ and $V_3$ are compared by the processing unit 25. If the voltage drop $V_1$ is equal to $V_3$ (block 88) indicating a short circuit in the bus 23, a signal is generated to activate a second alarm (block 90). If the voltage drop $V_3$ is not equal to $V_1$, the processing unit 25 will then compare (block 92) the voltage drop $V_3$ with $V_2$. If $V_3$ is greater than $V_2$ indicating an open circuit at point A (Fig. 1) in the circuit, a third alarm is activated (block 94). If $V_2$ is greater than $V_3$ indicating the bus voltage level supplied by the voltage source 21 (Fig. 1) is zero, a fourth alarm 96 is activated.

It will thus be seen that with this method and apparatus for detecting a fault in a voltage bus, various fault conditions can be automatically determined and an alarm activated which notifies the operator of the nature of the fault.

## Claims

1. A method for detecting a fault in a voltage distribution bus (20) adapted to be supplied with a line voltage level by a voltage supply (21) and which is connected to utilization means (19) utilizing the line voltage, characterized by the steps of: connecting a test circuit including a resistor network (22) and a data acquisition circuit (24) to said voltage distribution bus (20) such that said resistor network (22) is connected between said voltage distribution bus (20) and ground, supplying a current through a first circuit path in said data acquisition circuit (24) and sensing a first voltage drop ($V_1$) in said first circuit path, forming a second circuit path including a first resistor (44) in said test circuit, passing said current through said second circuit path, and sensing a second voltage drop ($V_2$) in said second circuit path, forming a third circuit path including a second resistor (28) having a greater resistance than the first resistor and included in said resistor network (22), passing said current through said third circuit path and sensing a third voltage drop ($V_3$) in said third circuit path, comparing the third voltage drop ($V_3$) with either the second voltage drop ($V_2$) and/or the first voltage drop and/or the maximum detectable voltage drop ($V_{max}$), and generating a respective one out of a number of alarm actuating signals when (a) the second voltage drop ($V_2$) is greater than the third voltage drop ($V_3$), (b) the third voltage drop ($V_3$) is greater than the second voltage drop ($V_2$), (c) the first voltage drop ($V_1$) is equal to the third voltage drop ($V_3$), (d) the third voltage drop ($V_3$) is greater than the maximum detectable voltage drop ($V_{max}$).

2. A method according to claim 1, characterized by the step of generating a first a1arm actuating signal (96) representing a failure of said voltagesupply (21) when the second voltage drop ($V_2$) is greater than the third voltage drop ($V_3$).

3. A method according to claim 1, characterized by the step of generating a second alarm actuating signal (94) representing an open circuit in the connection of said resistor network (22) to said voltage bus (20) when the third voltage drop ($V_3$) is greater than the second voltage drop ($V_2$).

4. A method according to claim 1, characterized by the steps of: comparing the first and third voltage drops ($V_1$, $V_3$) and generating a third alarm actuating signal (90) indicating a short circuit in said data acquisition circuit (24) when the first voltage drop ($V_1$) is equal to the third voltage drop ($V_3$).

5. A method according to claim 1, characterized by the step of generating a fourth alarm actuating signal (86), representing an open circuit between said resistor network (22) and said data acquisition circuit (24) when said third voltage drop ($V_4$) is greater than a predetermined value ($V_{max}$).

6. A test circuit for detecting a fault condition in a voltage distribution bus (20) adapted to be supplied with a line voltage by a voltage supply (21) and which is connected to utilization means (19) utilizing the line voltage, characterized in that said test circuit includes a resistor network (22) adapted for connection between said voltage distribution bus (20) and ground, and a data acquisition circuit (24) adapted for connection to said resistor network (22) and including voltage sensing means (32) connected to an output of said data acquisition circuit (24), and in that there are provided first switching means (42) adapted to connect a first circuit path in said data acquisition circuit (24) to said voltage sensing means (32), second switching means (40) adapted to connect a second circuit path including a first resistor (44) to said voltage sensing means (32), third switching means (38) adapted to connect a second resistor (28) having a value greater than said first resistor (44) and included in said resistor network (22) to said voltage sensing means (32), and fourth switching means (52, 60) adapted to connect a current source (58) to said data acquisition circuit (24), and processor means (25) responsive to the output of said voltage sensing means (32) and adapted to operate said fourth switching means (52,60) and to successively operate said first, second and third switching means (42, 40, 38) thereby providing respective first, second and third voltage drops ($V_1$, $V_2$, $V_3$), whereby said processor means (25) is adapted to generate a respective one of a number of alarm actuating signals when (a) the second voltage drop ($V_2$) is greater than the third voltage drop ($V_3$), (b) the third voltage drop ($V_3$) is greater than the second voltage drop ($V_2$), (c) the first voltage drop ($V_1$) is equal to the third voltage drop ($V_3$), (d) the third voltage drop ($V_3$) is greater than the maximum detectable voltage drop ($V_{max}$).

7. A test circuit according to claim 6, characterized in that said processor means (25) is adapted to generate a first alarm actuating signal (96) to indicate a first fault condition when said second voltage drop ($V_2$) is greater than said third voltage drop ($V_2$).

8. A test circuit according to claim 6, characterized in that said processor means (25) is adapted to generate a second alarm actuating signal (94) to indicate a second fault condition when said third voltage drop ($V_3$) is greater than said second voltage drop ($V_2$).

9. A test circuit according to claim 6 characterized in that said processor means (25) is adapted to generate a third alarm actuating signal (90) to indicate a third fault condition when said first voltage drop ($V_2$) is equal to said third voltage drop ($V_3$).

10. A test circuit according to claim 6, characterized in that said processor means (25) is adapted to generate a fourth alarm actuating signal (86) to indicate a fourth fault condition when said third voltage drop ($V_2$) is greater than a predetermined value ($V_{max}$).

**Patentansprüche**

1. Verfahren zum Feststellen eines Fehlers in einer Spannungsverteilungssammelschaltung (20), die geeignet ist, von einer Spannungsquelle (21) mit einem Leitungsspannungspegel versorgt zu werden, und die mit einer Verwendungsvorrichtung (19) verbunden ist, und die diese Leitungsspannung verwendet, gekennzeichnet durch die Schritte:

Verbinden einer ein Widerstandsnetzwerk (22) und eine Datenerfassungsschaltung (24) aufweisenden Testschaltung mit der Spannungsverteilungssammelleitung derart, daß das Widerstandsnetzwerk (22) zwischen der Spannungsverteilungsleitung (20) und Erde geschaltet ist, Zuführen eines Stromes zu der Datenerfassungsschaltung (24) durch einen ersten Schaltungsweg und Abfühlen eines ersten Spannungsabfalls ($V_1$) in dem ersten Schaltungsweg, Bilden eines zweiten Schaltungsweges, der einen ersten Widerstand (44) in der Testschaltung einschließt, Durchleiten des Stromes durch den zweiten Spannungsweg und Abfühlen eines zweiten Spannungsabfalls ($V_2$) in dem zweiten Schaltungsweg, Bilden eines dritten Schaltungsweges mit einem zweiten Widerstand (28), der einen größeren Widerstandswert als der erste Widerstand hat und in dem Widerstandsnetzwerk (22) enthalten ist, Durchleiten des Stromes durch den dritten Schaltungsweg und Abfühlen eines dritten Spannungsabfalls ($V_3$) in dem dritten Schaltungsweg, Vergleichen des dritten Spannungsbfalls ($V_3$) entweder mit dem zweiten Spannungsabfall ($V_2$) und/oder dem ersten Spannungsabfall und/oder dem maximal feststellbaren Spannungsabfall ($V_{max}$) und Erzeugen eines entsprechenden von einer Anzahl von Alarmbetätigungssignalen, wenn

(a) der zweite Spannungsabfall ($V_2$) größer als der dritte Spannungsabfall ($V_3$) ist,

(b) der dritte Spannungsabfall ($V_3$) größer als der zweite Spannungsabfall ($V_2$) ist,

(c) der erste Spannungsabfall ($V_1$) gleich dem dritten Spannungsabfall ($V_3$) ist,

(d) der dritte Spannungsabfall ($V_3$) größer als der maximal feststellbare Spannungsabfall ($V_{max}$) ist.

2. Verfahren nach Anspruch 1, gekennzeichnet durch den Schritt Erzeugen eines ersten Alarmbetätigungssignals (96), das eine Fehlfunktion der Spannungsquelle (21) darstellt, wenn der zweite Spannungsabfall ($V_2$) größer als der dritte Spannungsabfall ($V_3$) ist.

3. Verfahren nach Anspruch 1, gekennzeichnet durch den Schritt Erzeugen eines zweiten Alarmbetätigungssignals (94), das eine offene Schaltung in der Verbindung des Widerstandsnetzwerks (22) mit der Spannungssammelleitung (20) darstellt, wenn der dritte Spannungsabfall ($V_3$) größer als der zweite Spannungsabfall ($V_2$) ist.

4. Verfahren nach Anspruch 1, gekennzeichnet durch die Schritte: Vergleichen des ersten und dritten Spannungsabfalls ($V_1$,$V_3$) und Erzeugen eines dritten Alarmbetätigungssignals (90), das einen Kurzschluß in der Datenerfassungsschaltung (24) anzeigt, wenn der erste Spannungsabfall ($V_1$) gleich dem dritten Spannungsabfall ($V_3$) ist.

5. Verfahren nach Anspruch 1, gekennzeichnet durch den Schritt Erzeugen eines vierten Alarmbetätigungssignals (86), das eine offene Schaltung zwischen dem Widerstandsnetzwerk (22) und der Datenerfassungsschaltung (24) darstellt, wenn der dritte Spannungsabfall ($V_3$) größer als ein vorbestimmter Wert ($V_{max}$) ist.

6. Testschaltung zum Feststellen eines Fehlerzustandes in einer Spannungsverteilungssammelleitung (20), die geeignet ist, von einer Spannungsquelle (21) mit einer Leitungsspannung versorgt zu werden, und die mit einer Verwendungsvorrichtung (19) verbunden ist, die diese Leitungsspannung verwendet, dadurch gekennzeichnet, daß die Testschaltung ein Widerstandsnetzwerk (22) aufweist, das zur Verbindung zwischen der Spannungssammelleitung (20) und Erde geeignet ist, und eine Datenerfassungsschaltung (24) aufweist, die zur Verbindung mit dem Widerstandsnetzwerk (22) geeignet ist und eine Spannungsabfühlvorrichtung (32) aufweist, die an einen Ausgang der Datenerfassungsschaltung (24) angeschlossen ist, und daß vorgesehen sind: eine erste Schaltvorrichtung (42), die geeignet ist, einen ersten Schaltungsweg in der Datenerfassungsschaltung (24) zu der Spannungsabfühlvorrichtung (32) herzustellen, eine zweite Schaltvorrichtung (40), die geeignet ist, einen zweiten Schaltungsweg einschließlich eines ersten Widerstandes (44) zu der Spannungsabfühlvorrichtung (32) herzustellen, eine dritte Schaltvorrichtung (38), die geeignet ist, einen zweiten Widerstand (28) mit größerem als derjenige des ersten Widerstands (44) im Widerstandsnetzwerk (22) mit der Spannungsabfühlvorrichtung (32) zu verbinden, und vierte Schaltvorrichtungen (52, 60), die geeignet sind, eine Stromquelle (58) mit dem Datenfassungsnetzwerk (24) zu verbinden, und eine Verarbeitungsvorrichtung (25), die auf das Ausgangssignal der Spannungsabfühlvorrichtung (32) anspricht und geeignet ist, die vierten Schaltvorrichtungen (52, 60) zu betätigen und aufeinanderfolgend die erste, zweite und dritte Schaltvorrichtung (42, 40, 38) zu betätigen, wodurch sich erste, zweite und dritte Spannungsabfälle ($V_1$,$V_2$,$V_3$) ergeben, wobei die Verarbeitungsvorrichtung (25) geeignet ist, ein entsprechendes einer Anzahl von Alarmbetätigungssignalen zu erzeugen, wenn

(a) der zweite Spannungsabfall ($V_2$) größer als der dritte Spannungsabfall ($V_3$) ist,

(b) der dritte Spannungsabfall ($V_3$) größer als der zweite Spannungsabfall ($V_2$) ist,

(c) der erste Spannungsabfall ($V_1$) gleich dem dritten Spannungsabfall ($V_3$) ist,

(d) der dritte Spannungsabfall ($V_3$) größer als der maximal feststellbare Spannungsabfall ($V_{max}$) ist.

7. Testschaltung nach Anspruch 6, dadurch gekennzeichnet daß, die Verarbeitungsvorrichtung (25) geeignet ist, ein erstes Alarmbetätigungssignal (96) zu erzeugen, das einen ersten Fehlerzustand anzeigt, wenn der zweite Spannungsabfall ($V_2$) größer als der dritte Spannungsabfall ($V_3$) ist.

8. Testschaltung nach Anspruch 6, dadurch gekennzeichnet, daß die Verarbeitungsvorrichtung (25) geeignet ist, ein zweites Alarmbetätigungssignal (94) zu erzeugen, um einen zweiten Fehlerzustand anzuzeigen, wenn der dritte Spannungsabfall ($V_3$) größer als der zweite Spannungsabfall ($V_2$) ist.

9. Testschaltung nach Anspruch 6, dadurch gekennzeichnet, daß die Verarbeitungsvorrichtung (25) geeignet ist, ein drittes Alarmbetätigungssignal (90) zu erzeugen, um einen dritten Fehlerzustand anzuzeigen, wenn der erste Spannungsabfall ($V_1$) gleich dem dritten Spannungsabfall ($V_3$) ist.

10. Testschaltung nach Anspruch 6, dadurch gekennzeichnet, daß die Verarbeitungsvorrichtung (25) geeignet ist, ein viertes Alarmbetätigungssignal (86) zu erzeugen, um einen vierten Fehlerzustand anzuzeigen, wenn der dritte Spannungsabfall ($V_3$) größer als ein vorbestimmter Wert ($V_{max}$) ist.

## Revendications

1. Procédé pour détecter un défaut dans un bus (20) de distribution de tension conçu pour être alimenté à un niveau de tension de ligne à partir d'une alimentation (21) en tension et qui est connecté à des moyens d'utilisation (19) utilisant la tension de ligne, caractérisé par les étapes qui consistent: à connecter un circuit d'essai comprenant un réseau de résistances (22) et un circuit (24) d'acquisition de données audit bus (20) de distribution de tension afin que ledit réseau (22) de résistances soit connecté entre ledit bus (20) de distribution de tension et la masse, à fournir un courant par un premier trajet de circuit audit circuit (24) d'acquisition de données et à détecter une première chute de tension ($V_1$) dans ledit premier trajet de circuit, à former un deuxième trajet de circuit comprenant une première résistance (44) dans ledit circuit d'essai, à faire passer ledit courant dans ledit deuxième trajet de circuit et à détecter une deuxième chute de tension ($V_2$) dans ledit deuxième trajet de circuit, à former un troisième trajet de circuit comprenant une seconde résistance (28) ayant une valeur plus grande que celle de la première résistance et incorporée dans ledit réseau (22) de résistances, à faire passer ledit courant dans ledit troisième trajet de circuit et détecter une troisième chute de tension ($V_3$) dans ledit troisième trajet de circuit, à comparer la troisième chute de tension ($V_3$) à la deuxième chute de tension ($V_2$) et/ou à la première chute de tension et/ou à la chute de tension maximale décelable ($V_{max}$), et à générer l'un, respectif, d'un certain nombre de signaux de déclenchement d'alarme lorsque (a) la deuxième chute de tension ($V_2$) est supérieure à la troisième chute de tension ($V_3$), (b) la troisième chute de tension ($V_3$) est supérieure à la deuxième chute de tension ($V_2$), (c) la première chute de tension ($V_1$) est égale à la troisième chute de tension ($V_3$), (d) la troisième chute de tension ($V_3$) est supérieure à la chute de tension maximale décelable ($V_{max}$).

2. Procédé selon la revendication 1, caractérisé par l'étape qui consiste à générer un premier signal (96) de déclenchement d'alarme représentant une défaillance de ladite alimentation (21) en tension lorsque la deuxième chute de tension ($V_2$) est supérieure à la troisième chute de tension ($V_3$).

3. Procédé selon la revendication 1, caractérisé par l'étape qui consiste à générer un second signal (94) de déclenchement d'alarme représentant un circuit ouvert dans la connexion dudit réseau (22) de résistances sur ledit bus (20) de tension lorsque la troisième chute de tension ($V_3$) est supérieure à la deuxième chute de tension ($V_2$).

4. Procédé selon la revendication 1, caractérisé par les étapes qui consistent: à comparer les première et troisième chutes de tension ($V_1$, $V_3$) et

à générer un troisième signal (90) de déclenchement d'alarme indiquant un court-circuit dans ledit circuit (24) d'acquisition de données lorsque la première chute de tension ($V_1$) est égale à la troisième chute de tension ($V_3$).

5. Procédé selon la revendication 1, caractérisé par les étapes qui consistent à générer un quatrième signal (86) de déclenchement d'alarme, représentant un circuit ouvert entre ledit réseau (22) de résistances et ledit circuit (24) d'acquisition de données lorsque ladite troisième chute de tension ($V_4$) est supérieure à une valeur prédéterminée ($V_{max}$).

6. Circuit d'essai pour détecter une condition de défaut dans un bus (20) de distribution de tension conçu pour être alimenté par une tension de ligne par une alimentation en tension (21) et qui est connecté à des moyens d'utilisation (19) utilisant la tension de ligne, caractérisé en ce que ledit circuit d'essai comprend un réseau (22) de résistances conçu pour une connexion entre ledit bus (20) de distribution de tension et la masse, et un circuit (24) d'acquisition de données conçu pour une connexion sur ledit réseau (22) de résistances et comprenant des moyens (32) de détection de tension connectés à une sortie dudit circuit (24) d'acquisition de données, et en ce qu'il est prévu un premier moyen (42) de commutation conçu pour connecter un premier trajet de circuit, situé dans ledit circuit (24) d'acquisition de données, auxdits moyens (32) de détection de tension, un deuxième moyen (40) de commutation conçu pour connecter un deuxième trajet de circuit, comprenant une première résistance (44), auxdits moyens (32) de détection de tension, un troisième moyen (38) de commutation conçu pour connecter une seconde résistance (28), d'une valeur supérieure à celle de ladite première résistance (44) et montée dans ledit réseau (22) de résistances, auxdits moyens (32) de détection de tension, et un quatrième moyen de commutation (52, 60) conçu pour connecter une source de courant (58) audit circuit (24) d'acquisition de données, et des moyens processeurs (25) sensibles au signal de sortie desdits moyens (32) de détection de tension et conçus pour actionner ledit quatrième moyen (52, 60) de commutation et pour actionner successivement lesdits premier, deuxième et troisième moyens (42, 40, 38) de commutation afin de produire des première, deuxième et troisième chutes respectives de tension ($V_1$, $V_2$, $V_3$), lesdits moyens processeurs (25) étant conçus pour générer l'un, respectif, d'un certain nombre de signaux de déclenchement d'alarme lorsque (a) la deuxième chute de tension ($V_2$) est supérieure à la troisième chute de tension ($V_3$), (b) la troisième chute de tension ($V_3$) est supérieure à la deuxième chute de tension ($V_2$), (c) la première chute de tension ($V_1$) est égale à la troisième chute de tension ($V_3$), (d) la troisième chute de tension ($V_3$) est supérieure à la chute de tension maximale décelable ($V_{max}$).

7. Circuit d'essai selon la revendication 6, caractérisé en ce que lesdits moyens processeurs (25) sont conçus pour générer un premier signal (96) de déclenchement d'alarme afin d'indiquer une première condition de défaut lorsque ladite deuxième chute de tension (V$_2$) est supérieure à ladite troisième chute de tension (V$_3$).

8. Circuit d'essai selon la revendication 6, caractérisé en ce que lesdits moyens processeurs (25) sont conçus pour générer un deuxième signal (94) de déclenchement d'alarme pour indiquer une deuxième condition de défaut lorsque ladite troisième chute de tension (V$_3$) est supérieure à ladite deuxième chute de tension (V$_2$).

9. Circuit d'essai selon la revendication 6, caractérisé en ce que lesdits moyens processeurs (25) sont conçus pour générer un troisième signal (90) de déclenchement d'alarme afin d'indiquer une troisième condition de défaut lorsque ladite première chute de tension (V$_2$) est égale à ladite troisième chute de tension (V$_3$).

10. Circuit d'essai selon la revendication 6, caractérisé en ce que lesdits moyens processeurs (25) sont conçus pour générer un quatrième signal (86) de déclenchement d'alarme pour indiquer une quatrième condition de défaut lorsque ladite troisième chute de tension (V$_3$) est supérieure à une valeur prédéterminée (V$_{max}$).

EP 0 214 239 B1

FIG. 1

FIG. 2

FIG. 3

```
┌─────────────────────────────┐
│      SENSE ZERO VOLTAGE      │
│ WITH SWITCHES 38 AND 50 CLOSED │
└─────────────────────────────┘
              │
              ▼
┌─────────────────────────────┐
│   CLOSE SWITCHES 42,52, AND 60 │
│     OPEN SWITCH 38 TO APPLY    │
│      CURRENT TO THE CIRCUIT    │
└─────────────────────────────┘
              │
              ▼
┌─────────────────────────────┐
│     SENSE VOLTAGE V₁ AT      │
│     AMPLIFIER 32 INPUT        │
└─────────────────────────────┘
              │
              ▼
┌─────────────────────────────┐
│     OPEN SWITCH 42 AND       │
│     CLOSE SWITCH 40          │
└─────────────────────────────┘
              │
              ▼
┌─────────────────────────────┐
│     SENSE VOLTAGE V₂ AT      │
│     AMPLIFIER 32 INPUT       │
└─────────────────────────────┘
              │
              ▼
┌─────────────────────────────┐
│     CLOSE SWITCH 38          │
│     AND OPEN SWITCH 40       │
└─────────────────────────────┘
              │
              ▼
┌─────────────────────────────┐
│     SENSE VOLTAGE V₃ AT      │
│     AMPLIFIER 32 INPUT       │
└─────────────────────────────┘
```

Flowchart of Figure 3:

- **70** — SENSE ZERO VOLTAGE WITH SWITCHES 38 AND 50 CLOSED
- **72** — CLOSE SWITCHES 42, 52, AND 60 OPEN SWITCH 38 TO APPLY CURRENT TO THE CIRCUIT
- **74** — SENSE VOLTAGE $V_1$ AT AMPLIFIER 32 INPUT
- **76** — OPEN SWITCH 42 AND CLOSE SWITCH 40
- **78** — SENSE VOLTAGE $V_2$ AT AMPLIFIER 32 INPUT
- **80** — CLOSE SWITCH 38 AND OPEN SWITCH 40
- **82** — SENSE VOLTAGE $V_3$ AT AMPLIFIER 32 INPUT
- **84** — $V_3 > V_{MAX}$ ? — YES → **86** ACTUATE ALARM I
- NO ↓
- **88** — $V_3 = V_1$ ? — YES → **90** ACTUATE ALARM II
- NO ↓
- **92** — $V_3 > V_2$ ? — YES → **94** ACTUATE ALARM III
- NO → **96** ACTUATE ALARM IV